# FASCICULE DE BREVET EUROPEEN

(11) **EP 2 210 457 B1**
(45) Date de publication et mention de la délivrance du brevet: **04.06.2014**
(21) Numéro de dépôt: 08871932.3
(22) Date de dépôt: 12.11.2008
(51) Int. Cl.: H05K 1/16

(54) **PROCÉDÉ DE FABRICATION D'UN COMPOSANT À FONCTION ÉLECTRONIQUE**
VERFAHREN ZUR HERSTELLUNG EINER KOMPONENTE MIT EINER ELEKTRONISCHEN FUNKTION
METHOD FOR MAKING A COMPONENT HAVING AN ELECTRONIC FUNCTION

(30) Priorité: 13.11.2007 FR 0707976
(43) Date de publication de la demande: 28.07.2010
(73) Titulaire: Eurofarad-EFD, 75011 Paris (FR); Ceradrop, 87000 Limoges (FR)
(72) Inventeur: LAVILLE, Henri, F-77400 Lagny-sur-Marne (FR); LANGLE, Arnaud, F-94000 Creteil (FR); NOGUERA, Rémi, F-87100 Limoges (FR)
(74) Mandataire: Novagraaf Technologies
(86) Numéro de dépôt international: PCT/FR2008/001590
(87) Numéro de publication internationale: WO 2009/095559

(56) Documents cités:
- JP-A- 2003 318 133
- US-A1- 2003 183 165

## Description

La présente invention concerne le domaine des procédés de fabrication de composants à fonction électronique. L'invention concerne en particulier, mais non exclusivement, un procédé de fabrication de condensateurs.

On connaît différents procédés pour la réalisation de composants à fonction électronique. La technique la plus classique pour la réalisation de condensateurs à base de matériaux céramiques consiste à réaliser différentes feuilles en matériau céramique, à l'aide de toute technique appropriée, par exemple coulage, dépôt par sérigraphie ou autres techniques équivalentes, empiler les feuilles de matériau céramique ainsi réalisées, soumettre cet empilement à une thermocompression, puis découper l'ensemble ainsi obtenu pour former des condensateurs unitaires.

D'autres techniques, visant à réduire le nombre d'étapes opératoires, ont été expérimentées ou utilisées, avec, parfois, comme ce fut le cas avec la technique bien connue du « procédé humide » (wet process, selon la terminologie anglo-saxonne), des résultats significatifs. Mais aucune de ces techniques ne permet d'optimiser l'accrochage des couches céramiques entre elles.

On connaît notamment un procédé de réalisation de composants multi-matériaux tridimensionnels par dépôt de jets d'encre décrit, par exemple, dans le document FR-A-2859128. Ce document décrit un procédé de dépôt de couches d'impression successives de céramiques et de matériaux métalliques. Ce procédé introduit en outre, comme indiqué page 16, lignes 22 à 26, pour une couche, donnée, un état de surface d'une certaine rugosité, de manière à influencer l'agencement, en termes d'étalement et de dispersion, du matériau qui sera ensuite déposé sur cette couche.

En théorie, un tel procédé devrait permettre d'améliorer la rentabilité de fabrication et la performance des produits obtenus. En effet, ce procédé permet surtout d'optimiser une caractéristique importante du composant, l'isotropie, de manière à obtenir une cohésion améliorée du composant et à augmenter sa résistance mécanique, comme indiqué dans le document FR-A-2859128, page 17, lignes 25 à 34. Cependant, à ce jour, la mise en oeuvre du procédé décrit dans le document FR-A-2859128 pour la réalisation de composants à fonction électronique ne donne pas toujours totalement satisfaction.

On connaît encore un procédé de fabrication de composants électroniques passifs par dépôt de jets d'encre, décrit dans le document WO 2006/076607 A1. Ce document propose d'utiliser une encre choisie pour ses coefficients d'adhésion et d'expansion thermique, de manière à assurer la stabilité et la compatibilité de cette encre avec d'autres encres devant être utilisées pour la réalisation d'autres couches d'impression, comme indiqué dans le document WO 2006/076607 A1, page 8, paragraphe [0033]. Or, ce procédé ne donne pas totalement satisfaction en termes de liaison entre les couches d'impression.

US 2003/183165A1 décrit un procédé pour fabriquer une pièce électronique de type empilé.

Un but de la présente invention est de fournir un procédé de réalisation de composants multi-matériaux tridimensionnels répondant aux inconvénients de l'Art antérieur susmentionnés.

A ce titre, l'invention propose un procédé de réalisation d'un composant multi-matériaux tridimensionnel composé d'au moins un premier et un second matériau. Le procédé consiste à réaliser au moins deux couches d'impression superposées selon des trajectoires spatiales discrètes de parcours d'impression, les couches d'impression étant exécutées par dépôt sans contact d'impacts localisés de gouttes d'impression, et :
- une couche d'impression homogène N_{A} est constituée par au moins le premier matériau à l'exclusion du second matériau, et
- au moins une couche d'impression mixte N_{I} est constituée par le premier matériau et au moins le second matériau.

De préférence, au moins une autre couche d'impression mixte N_{I+1} est superposée à la couche d'impression mixte précédente N_{I}.

Avantageusement, le premier matériau de la couche d'impression mixte N_{I+1} est sensiblement superposé au premier matériau de la couche d'impression mixte précédente N_{I}.

De préférence, une pluralité de couches d'impression mixtes sont déposées successivement, formant une première couche mince mixte M_{I} présentant des reliefs complémentaires de premier et second matériaux.

Avantageusement, une pluralité de couches d'impression homogènes N_{A} constituées par au moins le premier matériau à l'exclusion du second matériau et formant une couche mince homogène M_{A} sont déposées successivement sur la première couche mince mixte M_{I}.

Alternativement, une pluralité de couches d'impression homogènes N_{B} constituées par au moins le second matériau à l'exclusion du premier matériau et formant une couche mince homogène M_{B} sont déposées successivement sur la première couche mince mixte M_{I}.

De préférence, au moins deux autres couches minces, mixte M_{I} puis homogène M_{A}; M_{B}, sont déposées successivement sur la couche mince homogène M_{A}; M_{B} précédente.

Selon des exemples de réalisation particuliers :
- l'un au moins des reliefs complémentaires de premier et second matériaux présente une forme de dôme ;
- l'un au moins des reliefs complémentaires forme une traversée entre deux couches minces homogènes ;
- les gouttes d'impression projetées présentent au moins un constituant en phase liquide et au moins un constituant en phase solide de manière à former un mélange liquide ;
- la proportion volumique d'élément en phase solide au sein du mélange liquide est comprise entre 1 % et 50% ;
- la viscosité du mélange liquide projeté est comprise entre 1 et 40 mPa.s ;
- la tension de surface du mélange liquide projeté est comprise entre 20 et 70 mN/m ;
- les dépôts sont opérés sur un support en matériau évanescent, par exemple à base de graphite ou de papier, susceptible d'être détruit à haute température ;
- au moins l'un des matériaux déposés est à base de matériau céramique.
- le procédé peut être appliqué à la fabrication de condensateurs, de composants multi-fonctionnels résistifs capacitifs, inductifs capacitifs et résistifs inductifs capacitifs.

Selon un autre aspect, l'invention concerne également un composant multi-matériaux tridimensionnel susceptible d'être obtenu par la mise en oeuvre du procédé selon l'un quelconque des procédés de réalisation précités. Le composant comprend au moins deux couches d'impression exécutées par dépôt sans contact d'impacts localisés de gouttes d'impression, et :
- une couche d'impression homogène N_{A} comporte au moins un premier matériau à l'exclusion d'un second matériau, et
- au moins une couche d'impression mixte N_{I} comporte le premier et au moins un second matériau.

Avantageusement, le composant comporte en outre au moins une couche d'impression mixte N_{I+1}, superposée à la couche d'impression N_{I}.

De préférence, le premier matériau de la couche d'impression N_{I+1} est sensiblement superposé au premier matériau de la couche d'impression précédente N_{I}.

Avantageusement, le composant comporte une pluralité de couches d'impression mixtes formant une couche mince mixte M_{I} présentant des reliefs complémentaires de premier et second matériau.

De préférence, il comporte une pluralité de couches d'impression homogènes N_{A}, constituées par au moins le premier matériau à l'exclusion du second matériau et formant une couche mince homogène M_{A}, déposées successivement sur la première couche mince mixte M_{I}.

Alternativement, il comporte une pluralité de couches d'impression homogènes N_{B}, constituées par au moins le second matériau à l'exclusion du premier matériau et formant une couche mince homogène M_{B}, déposées successivement sur la première couche mince mixte M_{I}.

Avantageusement, il comporte au moins deux autres couches minces, mixtes M_{I} puis homogènes M_{A};M_{B}, déposées successivement sur la couche mince homogène M_{A};M_{B} précédente.

Selon des exemples de réalisation avantageux :
- l'un au moins des reliefs complémentaires présente une forme de dôme ;
- l'un au moins des reliefs complémentaires forme une traversée entre deux couches minces homogènes (M_{A};M_{B}).
- au moins l'un des matériaux déposés est à base de matériau céramique.

L'invention concerne enfin un composant multi-fonctionnel résistif capacitif, inductif capacitif et résistif inductif capacitif selon l'une quelconque des exemples de réalisation susmentionné.

Comme on l'exposera plus en détail par la suite, le procédé de de réalisation et le composant selon l'invention permettent d'améliorer la tenue, ou liaison, mécanique entre les différentes couches minces formant le composant.

Notamment, le fait de superposer des couches d'impression alternativement mixtes et homogènes permet d'assurer la liaison mécanique entre les couches minces.

Le fait d'obtenir des reliefs complémentaires de premier et second matériaux présentant une forme de dôme permet de lier plusieurs couches minces homogènes sans altérer la conductivité du composant. Par ailleurs, les reliefs complémentaires formant une traversée entre deux couches minces homogènes améliore sensiblement la tenue mécanique entre ces deux couches minces homogènes.

On entend ici par couche d'impression, une épaisseur élémentaire d'un dépôt localisé de gouttes d'impression réalisé selon une trajectoire spatiale discrète et formant un continuum. De ce fait, deux gouttes d'impression formant une même couche d'impression ne sont pas considérées comme superposées pour autant qu'elles ne se recouvrent que partiellement.

Au contraire, on entend par couches d'impression superposées, le dépôt successif d'au moins deux couches d'impression selon une direction constante sensiblement perpendiculaire à la surface de dépôt.

Par ailleurs, on entend par couche d'impression homogène, une couche d'impression formée par le dépôt d'au moins un premier matériau à l'exclusion d'un second matériau ou bien le dépôt d'au moins le second matériau à l'exclusion du premier matériau.

Au contraire, on entend par couche d'impression mixte, une couche d'impression présentant au moins les premier et second matériaux.

De la même façon, on entend par couche mince homogène, la superposition d'au moins deux couches d'impression homogènes et par couche mince mixte, la superposition d'au moins deux couches d'impression mixtes.

D'autres caractéristiques, buts et avantages de la présente invention apparaîtront à la lecture, qui suit, d'exemples de réalisation détaillés donnés à titres d'exemples non limitatifs et pour lesquels :
- la figure 1 représente une vue schématique en coupe transversale de deux couches d'impression homogène et mixte superposées selon un procédé de réalisation conforme à l'invention ;
- les figures 2a et 2b représentent trois couches d'impression superposées selon un procédé de réalisation conforme à l'invention ;
- les figures 3, 4, 5 et 6 représentent des vues en coupe transversale de cinq couches minces superposées selon un procédé de réalisation conforme à l'invention et pour lesquels plusieurs reliefs complémentaires de premier et second matériaux présentent une forme de dôme.
- La figure 7 représente une vue en coupe transversale de trois couches minces superposées selon un procédé de réalisation conforme à l'invention et pour lesquels plusieurs reliefs complémentaires de premier et second matériaux forment une traversée entre deux couches minces homogènes.

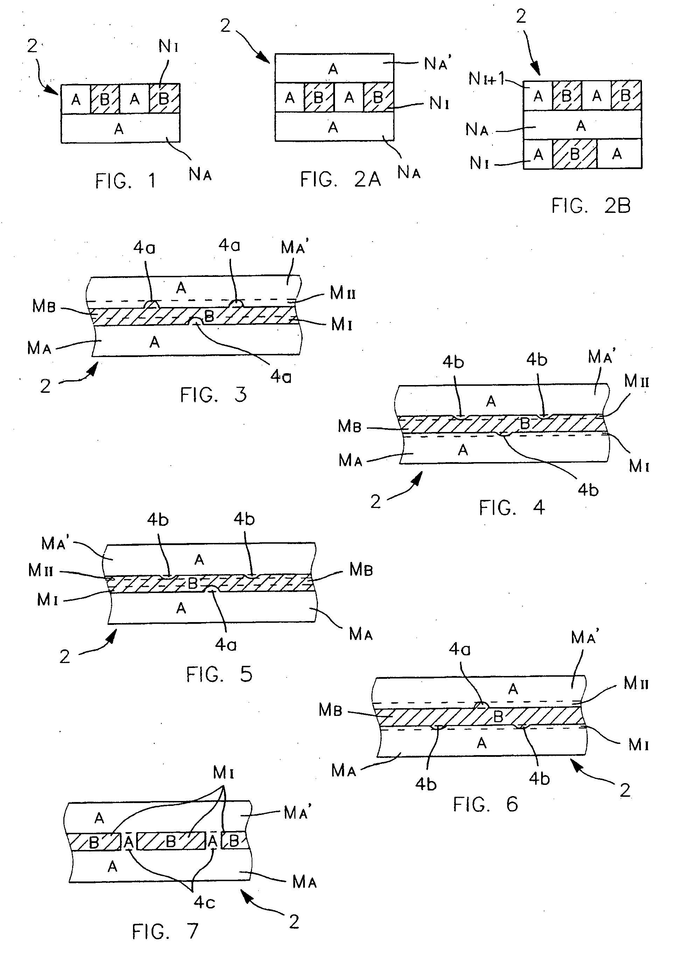

Un procédé de réalisation d'un composant 2 multi-matériaux tridimensionnel selon l'invention va maintenant être détaillé en référence à la figure 1. Dans cet exemple de réalisation, le composant 2 multi-matériaux tridimensionnel est réalisé par dépôt sans contact d'impacts localisés de gouttes d'impression selon une trajectoire spatiale discrète de parcours d'impression. Les impacts localisés de gouttes d'impression forment dans un premier temps une couche d'impression homogène N_{A} constituée par un premier matériau A. Dans un second temps, les impacts localisés de gouttes d'impression forment une couche d'impression mixte N_{I} constituée du premier matériau A et d'un second matériau B différent.

Les matériaux céramiques utilisés dans le cadre de la présente invention peuvent faire l'objet de nombreuses variantes de réalisation connues de l'homme de l'Art. Ils ne seront donc pas décrits dans le détail par la suite.

De la même façon, les figures 2a et 2b représentent schématiquement deux exemples de réalisation de composants 2 conformes à la présente invention. Dans la figure 2a, le composant 2 comprend une première couche d'impression homogène N_{A} sur laquelle est superposée une couche d'impression mixte N_{I}, puis une seconde couche d'impression homogène N_{A}'. Dans la figure 2b, le composant 2 comprend une première couche d'impression mixte N_{I} sur laquelle est superposée une couche d'impression homogène N_{A}, puis une seconde couche d'impression mixte N_{I+1}.

En pratique, le composant 2 final obtenu selon l'invention comprend, de préférence, un nombre plus important de couches d'impression N_{A}, N_{B}, N_{I}, N_{I+1} formées conformément au procédé de réalisation selon l'invention.

Selon un autre aspect, le procédé de réalisation selon l'invention permet de réaliser un composant 2 présentant au moins deux couches minces M_{A}, M_{B}, M_{I}, M_{II} chacune composée d'une pluralité de couches d'impression superposées N_{A}, N_{B}, N_{I}, N_{I+1}. Une couche mince formée par la superposition d'une pluralité de couches d'impression homogènes N_{A}, N_{B} est appelée couche mince homogène M_{A}, M_{B}. Au contraire, une couche mince formée par la superposition d'une pluralité de couches d'impression mixtes N_{I}, N_{I+1} est appelée couche mince mixte M_{I} ; M_{II}.

Selon un exemple de réalisation préféré, le premier matériau A d'une couche d'impression mixte N_{I+1} est sensiblement superposé au premier matériau A de la couche d'impression mixte précédente N_{I} de façon à former une couche mince mixte M_{I}; M_{I+1}, présentant des reliefs complémentaires de premier et second matériaux (A,B). Ces reliefs complémentaires assurent une liaison entre les différentes couches minces du composant 2. Il s'agit donc ici, non pas d'un état de surface pourvu d'une certaine rugosité permettant d'augmenter la résistance mécanique du composant 2, mais de véritables reliefs empêchant le déplacement relatif de deux couches minces homogènes superposées.

Un tel exemple de réalisation va maintenant être décrit en référence aux figures 3 à 6. Dans ces exemples de réalisation, une première couche mince homogène M_{A} est réalisée par le dépôt successif d'une pluralité de couches d'impression homogènes.

Une première couche mince mixte Mᵢ est ensuite superposée à la première couche mince homogène M_{A}. La première couche mince M_{I} présente des reliefs 4 complémentaires de premier et second matériaux (A,B).

Une seconde couche mince homogène M_{B} est ensuite superposée sur la couche mince mixte précédente M_{I}. L'homme de l'art comprendra aisément que les reliefs ainsi formés entre la première couche mince homogène M_{A} et la seconde couche mince homogène M_{B} permettent d'améliorer la cohésion mécanique entre ces couches minces homogènes M_{A},M_{B} et par conséquent la cohésion du composant 2 final. Enfin, une deuxième couche mince mixte M_{II} présentant également des reliefs 4 complémentaires, puis une troisième couche mince homogène M_{A}' sont successivement superposées sur la seconde couche mince homogène M_{B}.

Les reliefs 4 précités peuvent faire l'objet de nombreuses variantes de réalisation. Il peut s'agir de reliefs en saillie 4a tels que représentés sur la figure 3, ou bien de reliefs en creux 4b tels que représentés sur la figure 4. Il peut encore s'agir d'une combinaison de reliefs en saillie 4a et de reliefs en creux 4b, comme illustrés sur les figures 5 et 6.

Selon un exemple de réalisation préféré décrit en référence à la figure 7, le composant 2 présente une première couche mince homogène M_{A} sur laquelle est superposée une couche mince mixte M_{I} puis une seconde couche mince homogène M_{A}'. Dans cet exemple de réalisation, les première et seconde couches minces homogènes M_{A}, M_{A}' sont toutes deux formées à partir d'au moins un premier matériau A et à l'exclusion d'un second matériau B. Ainsi, les reliefs 4 complémentaires forment des traversées 4c de premier matériau A entre les première et seconde couches minces homogènes MA, M_{A}'.

De façon générale, ces traversées 4c constituées de matériau A sont formés localement dans une couche mince mixte comportant également un matériau B différent, de manière à relier au moins deux couches d'impression N_{A}, N_{A}' constituée au moins du même matériau A, à l'exclusion du second matériau B.

Les dépôts successifs de couches d'impression dans le cadre de la présente invention peuvent être réalisés selon toute technique connue de l'homme de l'Art. Il s'agit de préférence de dépôt par jets d'encre. Dans ce contexte, la Demanderesse a déterminé que différents paramètres d'encres déposées sont déterminants pour obtenir un composant 2 fonctionnel et fiable. Tout d'abord, les gouttes projetées sont constituées par au moins un constituant en phase solide et un constituant en phase liquide de manière à former un mélange liquide. De préférence, le taux volumique de charge minérale dans les encres déposées est sensiblement compris entre 1 et 50 %. Par ailleurs, de préférence, la viscosité des encres déposées est comprise entre environ 1 et environ 40 mPa.s. Enfin, la Demanderesse a déterminé que, de préférence, la tension superficielle des encres déposées est comprise entre environ 20 et environ 70 mN/m. Le dépôt par jets d'encre des couches formant le composant 2 conforme à la présente invention, peut être opéré sur tout support approprié.

Selon une variante de réalisation avantageuse, permettant d'éviter toute difficulté de séparation entre le composant 2 et le support précité recevant les couches d'impression N_{A}, N_{B}, N_{I}, N_{I+1} par jets d'encre en raison d'une porosité intrinsèque du support, ledit support est formé d'un matériau évanescent. C'est-à-dire que le matériau est destiné à être supprimé par toute technique appropriée une fois le composant 2, ou au moins la première couche d'impression N_{A}, N_{B}, N_{I}, réalisé. Plus précisément encore dans le cadre de la présente invention, à cette fin, la couche support recevant les dépôts par jets d'encre est formée d'un matériau susceptible d'être détruit à haute température, par exemple à base de graphite ou de papier de toute composition appropriée.

De préférence mais non limitativement, dans le cadre des exemples de réalisation représentés sur les figures 1, 2a et 2b, les couches d'impression mixtes N_{I}, N_{I+1} intègrent des charges électriquement conductrices tandis que les couches d'impression homogènes N_{A}, N_{A}' sont des couches en matériau électriquement isolant. Dans ce contexte, les couches d'impression mixtes N_{I}, N_{I+1} forment, par exemple, les armatures de condensateurs.

Toutefois, la présente invention n'est pas limitée à la réalisation de composants 2 de type condensateur. Elle englobe la réalisation de tout type de composant 2 à fonction électronique, par exemple des composants 2 intégrant des fonctions résistives et/ou inductives par utilisation d'encre résistive ou inductive sur des plages localisées. La présente invention permet ainsi de réaliser à titre de variantes des composants 2 multifonctionnels RC (résistifs et capacitifs), LC (inductifs et capacitifs) ou RLC (résistifs, inductifs et capacitifs).

Par ailleurs, certaines couches minces mixtes (non représentées) peuvent être formées à partir de couches d'impression mixte aléatoirement superposées de sorte que les matériaux A et B sont mélangés au sein de ces couches minces mixtes.

## Revendications

1. Procédé de réalisation d'un composant (2) multi-matériaux tridimensionnel composé d'au moins un premier et un second matériau (A,B), le procédé consistant à réaliser au moins deux couches d'impression superposées selon des trajectoires spatiales discrètes de parcours d'impression, les couches d'impression étant exécutées par dépôt sans contact d'impacts localisés de gouttes d'impression formant une couche d'impression homogène (N_{A}) constituée par au moins le premier matériau (A) à l'exclusion du second matériau (B), et au moins une couche d'impression mixte (N_{I}) est constituée par le premier matériau (A) et au moins le second matériau (B) ;
le procédé consistant à superposer au moins une autre couche d'impression mixte (N_{I+1}) à la couche d'impression mixte précédente (N_{I}) ; le premier matériau (A) de la couche d'impression mixte (N_{I+1}) étant sensiblement superposé au premier matériau (A) de la couche d'impression mixte précédente (N_{I}) ;
**caractérisé en ce qu**'une pluralité de couches d'impression mixtes sont déposées successivement, formant une première couche mince mixte (M_{I}) présentant des reliefs complémentaires de liaison des premier et second matériaux (A,B).

2. Procédé de réalisation selon la revendication 1, **caractérisé en ce qu'**une pluralité de couches d'impression homogènes (N_{A}) constituées par au moins le premier matériau (A) à l'exclusion du second matériau (B) et formant une couche mince homogène (M_{A}) sont déposées successivement sur la première couche mince mixte (M_{I}).

3. Procédé de réalisation selon la revendication 1 ou 2, **caractérisé en ce qu'**une pluralité de couches d'impression homogènes (N_{B}) constituées par au moins le second matériau (B) à l'exclusion du premier matériau (A) et formant une couche mince homogène (M_{B}) sont déposées successivement sur la première couche mince mixte (M_{I}).

4. Procédé de réalisation selon l'une quelconque des revendications 1 à 3, **caractérisé en ce qu'**au moins deux autres couches minces, mixte (M_{I}) puis homogène (M_{A};M_{B}), sont déposées successivement sur la couche mince homogène (M_{A};M_{B}) précédente.

5. Procédé selon l'une quelconque des revendications 1 à 4, **caractérisé en ce que** l'un au moins des reliefs complémentaires de liaison des premier et second matériaux (A,B) présente une forme de dôme.

6. Procédé selon l'une quelconque des revendications 1 à 5, **caractérisé en ce que** l'un au moins des reliefs complémentaires forme une traversée entre deux couches minces homogènes.

7. Procédé selon l'une quelconque des revendications 1 à 6, **caractérisé en ce que** les gouttes d'impression projetées présentent au moins un constituant en phase liquide et au moins un constituant en phase solide de manière à former un mélange liquide.

8. Procédé selon l'une quelconque des revendications 1 à 7, **caractérisé en ce que** la proportion volumique d'élément en phase solide au sein du mélange liquide est comprise entre 1 % et 50%.

9. Procédé selon l'une quelconque des revendications 1 à 8, **caractérisé en ce que** la viscosité du mélange liquide projeté est comprise entre 1 et 40 mPa.s.

10. Procédé selon l'une quelconque des revendications 1 à 9, **caractérisé en ce que** la tension de surface du mélange liquide projeté est comprise entre 20 et 70 mN/m.

11. Procédé selon l'une quelconque des revendications 1 à 10, **caractérisé en ce que** les dépôts sont opérés sur un support en matériau évanescent, susceptible d'être détruit à haute température.

12. Procédé selon l'une quelconque des revendications 1 à 11, **caractérisé en ce qu'**il peut être appliqué à la fabrication de condensateurs, de composants (2) multi-fonctionnels résistifs capacitifs, inductifs capacitifs et résistifs inductifs capacitifs.

13. Procédé selon l'une quelconque des revendications 1 à 12, **caractérisé en ce qu'**au moins l'un des matériaux (A,B) déposés est à base de matériau céramique.

14. Composant (2) multi-matériaux tridimensionnel susceptible d'être obtenu par la mise en oeuvre du procédé selon l'une quelconque des revendications 1 à 13, comprenant au moins deux couches d'impression exécutées par dépôt sans contact d'impacts localisés de gouttes d'impression formant une couche d'impression homogène (N_{A}) constituée d'au moins un premier matériau (A) à l'exclusion d'un second matériau (B), et au moins une couche d'impression mixte (N_{I}) constitué par le premier matériau (A) et au moins un second matériau (B);
Le composant comportant en outre au moins une couche d'impression mixte (N_{I+1}), superposée à la couche d'impression (N_{I}), le premier matériau (A) de la couche d'impression (N_{I+1}) étant sensiblement superposé au premier matériau (A) de la couche d'impression précédente (N_{I}).
**caractérisé en ce qu**'il comporte une pluralité de couches d'impression mixtes formant une couche mince mixte (M_{I}) présentant des reliefs complémentaires de liaison des premier et second matériaux (A,B).

15. Composant (2) selon la revendication 14, **caractérisé en ce qu'**il comporte une pluralité de couches d'impression homogènes (N_{A}), constituées par au moins le premier matériau (A) à l'exclusion du second matériau (B) et formant une couche mince homogène (M_{A}), déposées successivement sur la première couche mince mixte (M_{I}).

16. Composant (2) selon la revendication 14, **caractérisé en ce qu'**il comporte une pluralité de couches d'impression homogènes (N_{B}), constituées par au moins le second matériau (B) à l'exclusion du premier matériau (A) et formant une couche mince homogène (M_{B}), déposées successivement sur la première couche mince mixte (M_{I}).

17. Composant (2) selon l'une des revendications 15 ou 16, **caractérisé en ce qu'**il comporte au moins deux autres couches minces mixte (M_{I}) puis homogène (M_{A};M_{B}) déposées successivement sur la couche mince homogène (M_{A};M_{B}) précédente.

18. Composant (2) selon l'une quelconque des revendications 14 à 17, **caractérisé en ce que** l'un au moins des reliefs complémentaires présente une forme de dôme.

19. Composant (2) selon l'une quelconque des revendications 14 à 18, **caractérisé en ce que** l'un au moins des reliefs complémentaire forme une traversée entre deux couches minces homogènes (M_{A};M_{B}).

20. Composant (2) selon l'une quelconque des revendications 14 à 19, **caractérisé en ce qu'**au moins l'un des matériaux (A,B) déposés est à base de matériau céramique.

21. Condensateur ou composant (2) multi-fonctionnel résistif capacitif, inductif capacitif et résistif inductif capacitif selon l'une quelconque des revendications 14 à 20.

## Patentansprüche

1. Verfahren zur Herstellung einer dreidimensionalen, Komponente (2) aus mehreren Materialien, zusammengesetzt aus mindestens einem ersten und einem zweiten Material (A, B), wobei das Verfahren darin besteht, mindestens zwei übereinander gelegte Druckschichten gemäß diskreten räumlichen Wegen von Druckbahnen durchzuführen, wobei die Druckschichten durch die kontaktfreie Ablage von lokalisierten Anschlägen von Drucktropfen durchgeführt werden, die eine homogene Druckschicht (N_{A}) bilden, die aus mindestens dem ersten Material (A) mit Ausnahme des zweiten Materials (B) besteht, und wobei mindestens eine gemischte Druckschicht (N_{I}) aus dem ersten Material (A) und mindestens dem zweiten Material (B) besteht;
wobei das Verfahren darin besteht, mindestens eine weitere gemischte Druckschicht (N_{I+1}) über die vorhergehende gemischte Druckschicht (N_{I}) zu legen; wobei das erste Material (A) der gemischten Druckschicht (N_{I+1}) im Wesentlichen über das erste Material (A) der vorhergehenden gemischten Druckschicht (N_{I}) gelegt ist;
**dadurch gekennzeichnet, dass** eine Vielzahl von gemischten Druckschichten aufeinander folgend abgelegt sind und eine erste gemischte dünne Schicht (M_{I}) bilden, die komplementäre Verbindungsreliefs der ersten und zweiten Materialien (A, B) darstellen.

2. Herstellungsverfahren nach Anspruch 1, **dadurch gekennzeichnet, dass** seine Vielzahl von homogenen Druckschichten (N_{A}), die aus mindestens dem ersten Material (A) mit Ausnahme des zweiten Materials (B) bestehen und eine homogene dünne Schicht (M_{A}) bilden, aufeinander folgend auf der ersten gemischten dünnen Schicht (M_{I}) abgelegt sind.

3. Herstellungsverfahren nach Anspruch 1 oder 2, **dadurch gekennzeichnet, dass** eine Vielzahl von homogenen Druckschichten (N_{B}), die aus mindestens dem zweiten Material (B) mit Ausnahme des ersten Materials (A) bestehen und eine homogene dünne Schicht (M_{B}) bilden, aufeinander folgend auf der ersten gemischten dünnen Schicht (M_{I}) abgelegt sind.

4. Verfahren nach einem der Ansprüche 1 bis 3, **dadurch gekennzeichnet, dass** mindestens zwei weitere dünne, gemischte (M_{I}), dann homogene (M_{A}; M_{B}) Schichten aufeinander folgend auf der vorhergehenden homogenen dünnen Schicht (M_{A}; M_{B}) abgelegt sind.

5. Verfahren nach einem der Ansprüche 1 bis 4, **dadurch gekennzeichnet, dass** mindestens eines der komplementären Verbindungsreliefs der ersten und zweiten Materialien (A, B) die Form einer Kuppel aufweist.

6. Verfahren nach einem der Ansprüche 1 bis 5, **dadurch gekennzeichnet, dass** mindestens eines der komplementären Reliefs einen Durchgang zwischen zwei homogenen dünnen Schichten bildet.

7. Verfahren nach einem der Ansprüche 1 bis 6, **dadurch gekennzeichnet, dass** die projizierten Drucktropfen mindestens einen Bestandteil im flüssigen Zustand und mindestens einen Bestandteil im festen Zustand darstellen, um eine flüssige Mischung zu bilden.

8. Verfahren nach einem der Ansprüche 1 bis 7, **dadurch gekennzeichnet, dass** das Volumenverhältnis des Elements in festem Zustand in der flüssigen Mischung zwischen 1 % und 50 % liegt.

9. Verfahren nach einem der Ansprüche 1 bis 8, **dadurch gekennzeichnet, dass** die Viskosität der projizierten flüssigen Mischung zwischen 1 und 40 mPa.s. liegt.

10. Verfahren nach einem der Ansprüche 1 bis 9, **dadurch gekennzeichnet, dass** die Oberflächenspannung der projizierten flüssigen Mischung zwischen 20 und 70 mN/m liegt.

11. Verfahren nach einem der Ansprüche 1 bis 10, **dadurch gekennzeichnet, dass** die Ablagen auf einem Träger aus evaneszentem Material erfolgen, das bei hoher Temperatur zerstört werden kann.

12. Verfahren nach einem der Ansprüche 1 bis 11, **dadurch gekennzeichnet, dass** es auf die Herstellung von Kondensatoren, multifunktionalen, resistiv-kapazitiven, induktiv-kapazitiven und resistiv-induktiv-kapizitiven Komponenten (2) angewendet werden kann.

13. Verfahren nach einem der Ansprüche 1 bis 12, **dadurch gekennzeichnet, dass** mindestens eines der abgelegten Materialien (A, B) auf einem keramischen Material basiert.

14. Dreidimensionale Komponente (2) aus mehreren Materialien, die durch die Durchführung des Verfahrens nach einem der Ansprüche 1 bis 13 erhalten werden kann, umfassend mindestens zwei Druckschichten, die durch die kontaktfreie Ablage von lokalisierten Anschlägen von Drucktropfen durchgeführt werden, die eine homogene Druckschicht (N_{A}) bilden, die aus mindestens einem ersten Material (A) mit Ausnahme eines zweiten Materials (B) besteht, und mindestens einer gemischten Druckschicht (N_{I}), die aus dem ersten Material (A) und mindestens einem zweiten Material (B) besteht;
wobei die Komponente außerdem mindestens eine gemischte Druckschicht (N_{I+1}) umfasst, die über die Druckschicht (N_{I}) gelegt ist, wobei das erste Material (A) der Druckschicht (N_{I+1}) im Wesentlichen über das erste Material (A) der vorhergehenden Druckschicht (N_{I}) gelegt ist,
**dadurch gekennzeichnet, dass** sie eine Vielzahl von gemischten Druckschichten umfasst, die eine gemischte dünne Schicht (M_{I}) bilden, die komplementäre Verbindungsreliefs der ersten und zweiten Materialien (A, B) darstellen.

15. Komponente (2) nach Anspruch 14, **dadurch gekennzeichnet, dass** sie eine Vielzahl von homogenen Druckschichten (N_{A}) umfasst, die aus mindestens dem ersten Material (A) mit Ausnahme des zweiten Materials (B) bestehen und eine homogene dünne Schicht (M_{A}) bilden, die aufeinander folgend auf der ersten gemischten dünnen Schicht (M_{I}) abgelegt sind.

16. Komponente (2) nach Anspruch 14, **dadurch gekennzeichnet, dass** sie eine Vielzahl von homogenen Druckschichten (N_{B}) umfasst, die aus mindestens dem zweiten Material (B) mit Ausnahme des ersten Materials (A) bestehen, und eine homogene dünne Schicht (M_{B}) bilden, die aufeinander folgend auf der ersten gemischten dünnen Schicht (M_{I}) abgelegt sind.

17. Komponente (2) nach einem der Ansprüche 15 oder 16, **dadurch gekennzeichnet, dass** sie mindestens zwei weitere dünne, gemischte (M_{I}), dann homogene (M_{A}; M_{B}) Schichten umfasst, die aufeinander folgend auf der vorhergehenden homogenen dünnen Schicht (M_{A}; M_{B}) abgelegt sind.

18. Komponente (2) nach einem der Ansprüche 14 bis 17, **dadurch gekennzeichnet, dass** mindestens eines der komplementären Reliefs die Form einer Kuppel aufweist.

19. Komponente (2) nach einem der Ansprüche 14 bis 18, **dadurch gekennzeichnet, dass** mindestens eines der komplementären Reliefs einen Durchgang zwischen zwei homogenen dünnen Schichten (M_{A}; M_{B}) bildet.

20. Komponente (2) nach einem der Ansprüche 14 bis 19, **dadurch gekennzeichnet, dass** mindestens eines der abgelegten Materialien (A, B) auf einem keramischen Material basiert.

21. Multifunktionale(r), resistiv-kapazitive(r), induktiv-kapazitive(r) und resistiv-induktiv-kapazitive(r) Kondensator oder Komponente (2) nach einem der Ansprüche 14 bis 20.

## Claims

1. Method for producing a three-dimensional multimaterial component (2) consisting of at least one first and one second material (A, B), the method consisting of producing at least two overlaid printing layers along discrete spatial trajectories of printing paths, the printing layers being executed by contactless deposition of localised impacts of print drops forming a homogeneous printing layer (N_{A}) consisting of at least the first material (A) to the exclusion of the second material (B), and at least one mixed printing layer (N₁) consisting of the first material (A) and at least the second material (B);
the method consisting of overlaying at least one further mixed printing layer (N_{I+1}) on the preceding mixed printing layer (N_{I}); the first material (A) of the mixed printing layer (N_{I+1}) being substantially overlaid on the first material (A) of the preceding mixed printing layer (N_{I});
**characterised in that** a plurality of mixed printing layers are deposited successively, forming a first mixed thin layer (M_{I}) having complementary raised patterns for joining the first and second materials (A, B).

2. Production method according to claim 1, **characterised in that** a plurality of homogeneous printing layers (N_{A}) consisting of at least the first material (A) to the exclusion of the second material (B) and forming a homogeneous thin layer (M_{A}) are deposited successively on the first mixed thin layer (M_{I}).

3. Production method according to claim 1 or 2, **characterised in that** a plurality of homogeneous printing layers (N_{B}) consisting of at least the second material (B) to the exclusion of the first material (A) and forming a homogeneous thin layer (M_{B}) are deposited successively on the first mixed thin layer (M_{I}).

4. Production method according to any of claims 1 to 3, **characterised in that** at least two further mixed (M_{I}) and homogeneous (M_{A}; M_{B}) thin layers are deposited successively on the preceding homogeneous thin layer (M_{A}; M_{B}).

5. Method according to any of claims 1 to 4, **characterised in that** at least one of the complementary raised patterns for joining the first and second materials (A, B) has a dome shape.

6. Method according to any of claims 1 to 5, **characterised in that** at least one of the complementary raised patterns forms a bushing between two homogeneous thin layers.

7. Method according to any of claims 1 to 6, **characterised in that** the projected print drops have at least one liquid phase constituent and at least one solid phase constituent so as to form a liquid mixture.

8. Method according to any of claims 1 to 7, **characterised in that** the volume proportion of solid phase element in the liquid mixture is between 1% and 50%.

9. Method according to any of claims 1 to 8, **characterised in that** the viscosity of the projected liquid mixture is between 1 and 40 mPa.s.

10. Method according to any of claims 1 to 9, **characterised in that** the surface tension of the projected liquid mixture is between 20 and 70 mN/m.

11. Method according to any of claims 1 to 10, **characterised in that** the depositions are made on a substrate made of evanescent material, suitable for being destroyed at high temperatures.

12. Method according to any of claims 1 to 11, **characterised in that** it may be applied to the manufacture of capacitors, resistive capacitive, inductive capacitive and resistive inductive capacitive multi-functional components (2).

13. Method according to any of claims 1 to 12, **characterised in that** at least one of the materials (A, B) deposited is based on ceramic material.

14. Three-dimensional multi-material component (2) suitable for being obtained using the method according to any of claims 1 to 13, comprising at least two printing layers executed by contactless deposition of localised impacts of print drops forming a homogeneous printing layer (N_{A}) consisting of at least one first material (A) to the exclusion of a second material (B), and at least one mixed printing layer (N_{I}) consisting of the first material (A) and at least one second material (B);
the component further comprising at least one mixed printing layer (N_{I+1}) overlaid on the printing layer (N_{I}) ; the first material (A) of the mixed printing layer (N_{I+1}) being substantially overlaid on the first material (A) of the preceding mixed printing layer (N_{I}) ,
**characterised in that** it comprises a plurality of mixed printing layers forming a mixed thin layer (M_{I}) having complementary raised patterns for joining the first and second materials (A, B).

15. Component (2) according to claim 14, **characterised in that** it comprises a plurality of homogeneous printing layers (N_{A}) consisting of at least the first material (A) to the exclusion of the second material (B) and forming a homogeneous thin layer (M_{A}), deposited successively on the first mixed thin layer (M_{I}).

16. Component (2) according to claim 14, **characterised in that** it comprises a plurality of homogeneous printing layers (N_{B}) consisting of at least the second material (B) to the exclusion of the first material (A) and forming a homogeneous thin layer (M_{B}), deposited successively on the first mixed thin layer (M_{I}).

17. Component (2) according to any of claims 15 or 16, **characterised in that** it comprises at least two further mixed (M_{I}) and homogeneous (M_{A}; M_{B}) thin layers deposited successively on the preceding homogeneous thin layer (M_{A}; M_{B}).

18. Component (2) according to any of claims 14 to 17, **characterised in that** at least one of the complementary raised patterns has a dome shape.

19. Component (2) according to any of claims 14 to 18, **characterised in that in that** at least one of complementary raised patterns forms a bushing between two homogeneous thin layers (M_{A}; M_{B}).

20. Component (2) according to any of claims 14 to 19, **characterised in that** at least one of the materials (A, B) deposited is based on ceramic material.

21. Capacitor or resistive capacitive, inductive capacitive and resistive inductive capacitive multi-functional component (2) according to any of claims 14 to 20.
